(19) Europäisches Patentamt / European Patent Office / Office européen des brevets

(11) **EP 3 556 191 B1**

(12) **EUROPÄISCHE PATENTSCHRIFT**

(45) Veröffentlichungstag und Bekanntmachung des Hinweises auf die Patenterteilung:
**14.04.2021 Patentblatt 2021/15**

(21) Anmeldenummer: **17703092.1**

(22) Anmeldetag: **31.01.2017**

(51) Int Cl.:
**H05K 13/08** (2006.01)

(86) Internationale Anmeldenummer:
**PCT/EP2017/051997**

(87) Internationale Veröffentlichungsnummer:
**WO 2018/141356 (09.08.2018 Gazette 2018/32)**

(54) **VERFAHREN UND STEUERUNGSEINRICHTUNG ZUR DURCHSATZOPTIMIERTEN PRODUKTION VON LEITERPLATTEN AUF EINER BESTÜCKUNGSLINIE**

METHOD AND CONTROL DEVICE FOR THE THROUGHPUT-OPTIMISED PRODUCTION OF PRINTED CIRCUIT BOARDS ON A PICK-AND-PLACE LINE

PROCÉDÉ ET DISPOSITIF DE COMMANDE POUR LA PRODUCTION À RENDEMENT OPTIMISÉ DE CARTES DE CIRCUITS IMPRIMÉS SUR UNE LIGNE DE MONTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**23.10.2019 Patentblatt 2019/43**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**

(56) Entgegenhaltungen:
**WO-A1-2016/074857    DE-A1-102014 222 936**

**Beschreibung**

Die Erfindung betrifft ein Verfahren zur durchsatzoptimierten Produktion von Leiterplatten auf einer Bestückungslinie. Weiterhin betrifft die Erfindung eine Steuerungseinrichtung für ein Bestückungssystem bzw. eine Fertigungs- oder Montagelinie zur Bestückung von Leiterplatten (Baugruppen) mit Bauelementen bzw. Bauteilen. Außerdem betrifft die Erfindung ein Computerprogrammprodukt.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt. Ein Hersteller von SMT-Bestückungsautomaten (pick and place) und -systeme mit dem Produktnamen SIPLACE ist beispielsweise die Firma ASM (http://www.siplace.com/en/Home).

Mehrere Bestückungsautomaten, die üblicherweise durch ein Transportsystem verbunden sind, und die z.B. zum Fertigen bzw. zum Produzieren von (Elektronik-)bauteilen bzw. Leiterplatten zusammenwirken, stellen eine Bestückungslinie dar.

Bei Bestückungsautomaten z.B. zum Bestücken von Baugruppen mit Bauelementen werden seitlich an einer Transportstrecke für die Baugruppe Wechseltische für Zuführvorrichtungen für Bauelemente angeordnet.

Die Wechseltische umfassen jeweils eine Vielzahl Zuführungseinrichtungen. Jede Zuführungseinrichtung hält einen Vorrat von Bauelementen eines vorbestimmten Bauelementtyps bereit. Für die Bauelemente hat die Zuführungseinrichtung ein Fassungsvermögen (Platzkapazität), das üblicherweise in Spuren bzw. Spurkapazitäten ausgedrückt wird.

Jede Zuführungseinrichtung kann zur Bereithaltung unterschiedlicher Bauelemente konfiguriert werden und üblicherweise können unterschiedliche Zuführungseinrichtungen an einem Wechseltisch angebracht werden. Wird ein Bauelement eines Bauelementtyps an einem bestimmten Bestückungsautomaten benötigt, der nicht in einem der Wechseltische vorhanden ist, so wird üblicherweise nicht einer der angebrachten Wechseltische mit den benötigten Bauelementen versehen, sondern komplett gegen einen anderen, entsprechend bestückten Wechseltisch ausgetauscht. Das Aufrüsten eines einzuwechselnden Wechseltischs mit Bauelementen wird Vorrüstung genannt und kann eine Bearbeitungszeit im Stundenbereich erfordern.

Weiterhin ist es z.B. aus der Elektronikfertigung bekannt, die auf einer Bestückungslinie zu fertigenden Lose in Rüstfamilien zusammenzufassen. Alle Lose einer Rüstfamilie werden jeweils mit derselben Linienrüstung gefertigt. Eine Rüstfamilie, auch Cluster genannt, umfasst eine Menge von Losen, die innerhalb einer Rüstung gefertigt werden kann. Alle Baugruppen einer Rüstfamilie können also nacheinander ohne Umrüsten auf der Linie gefertigt werden.

Eine Rüstung kann auf einem oder mehreren Rüsttischen gehalten werden, die leicht am Bestückungsautomaten ausgewechselt werden können. Ein Aufrüsten eines Rüsttischs mit Bauelementen von vorbestimmten Bauelementtypen ist jedoch - wie oben bereits beschrieben - aufwändig. Die Rüstungen werden daher oft in Festrüstungen und Variantenrüstungen unterschieden, wobei ein Festrüstungstisch dazu vorgesehen ist, seine Zusammensetzung von Bauelementtypen über einen vorbestimmten Planungszeitraum zu behalten, während ein Variantenrüsttisch voraussichtlich innerhalb des Planungszeitraums umgerüstet wird.

Der typische Rüstbetrieb an einer SMT-Bestückungslinie innerhalb einer kurzfristigen Planungsperiode, beginnend bei der Planung bis hin zur Ausführung, sieht folgendermaßen aus:
Die Dauer eines kurzfristigen Planungszeitraums beträgt normalerweise zwischen ein und fünf Tagen. Zu Beginn einer Planungsperiode erhält der Produktionsplaner gewöhnlich aus einem EDV-System neue Fertigungsaufträge. Er hat aber auch noch einen Restbestand an alten, noch nicht eingeplanten Fertigungsaufträgen aus der Vorperiode. Die Aufträge werden, wenn möglich, mit bestehenden Festrüstungen gefertigt. Für den Rest werden variable Rüstungen (auch Variantenrüstungen genannt) erstellt.

Während mit einer aktiven Rüstung an der Bestückungslinie bestückt wird, wird im Vorrüstbereich bereits die nächste Rüstung auf einem für variable Rüstungen vorgehaltenen Wechseltischsatz vorbereitet. Eine Menge von pro Rüstung notwendigen Wechseltischen wird hierbei als Wechseltischsatz bezeichnet. Dauert die Vorbereitung zu lange, so kommt es zu einer Stillstandzeit der Bestückungslinie.

Auch Umrüstvorgänge für den Rüstwechsel von einer Rüstfamilie auf eine andere Rüstfamilie ziehen Stillstandzeiten von typischerweise 30 min nach sich.

Stillstandzeiten von Bestückungslinien mindern den Durchsatz der Bestückungslinie und sollten somit unbedingt vermieden werden.

In der Praxis werden die variablen Rüstungen gewöhnlich mit einem Cluster-Tool wie z.B. SiCluster erstellt. Die in einer zeitlichen Sequenz geordnete Rüstreihenfolge im Vorrüstbereich wird derzeit vom Produktionsplaner manuell erstellt.

Verfahren und Steuereinrichtungen zur durchsatzoptimierten Produktion von Leiterplatten auf einer Bestückungslinie sind beispielsweise aus DE 10 2014 222936 A1 und aus WO 2016/074857 A1 bekannt.

Es ist Aufgabe der vorliegenden Erfindung, den Durchsatz auf einer Bestückungslinie zu optimieren.

Diese Aufgabe wird durch die unabhängigen Ansprüche gelöst. Vorteilhafte Weiterbildungen sind Gegenstand der abhängigen Ansprüche.

Die Erfindung beansprucht ein Verfahren zur durchsatzoptimierten Produktion von Leiterplatten auf einer Bestückungslinie, wobei die Leiterplatten in Gruppen aufgeteilt sind, die Cluster genannt werden, wobei ein Cluster jeweils mittels einer Rüstung gefertigt wird, wobei die Rüstung durch an der Bestückungslinie anbringbare Wechseltische realisiert wird, die jeweils mindestens eine Zuführungseinrichtung zum Bereithalten von Vorräten von Bauelementen aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind,

- wobei eine Rüstung temporär auf leeren Wechseltischsätzen aufgerüstet und nach der Produktion von Leiterplatten durch deren Bestückung abgerüstet wird, und
- wobei einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

wobei das Verfahren folgende Schritte umfasst:

a) Erfassen einer Menge von Clustern,
b) Erfassen einer Anzahl an leeren Wechseltischsätzen,
c) Erfassen der jeweiligen Zeitdauer für das Erstellen der Rüstung für ein Cluster,
d) Erfassen der jeweiligen Produktionszeitdauer für die Fertigung eines Clusters auf der Bestückungslinie,
e) Auswählen einer Reihenfolge zur Verwendung der Wechseltischsätze zum Rüsten im Vorrüstbereich mit dem Ziel der Vermeidung von Wartezeiten in der Produktion, in welcher dieselben Wechseltischsätze zur Produktion der Leiterplatten eingesetzt werden,
f) Optimierung der Reihenfolge der Cluster unter Berücksichtigung der ausgewählten Reihenfolge zur Verwendung der Wechseltischsätze, so dass der Durchsatz auf der Bestückungslinie maximiert wird bzw. ist,
g) Durchführung der Produktion der Leiterplatten mit Hilfe der optimierten Reihenfolge der Cluster.

Ein leerer Wechseltischsatz weist in der Regel ungerüstetete bzw. noch nicht gerüstete Wechseltische auf. Die Zuführungseinrichtungen sind dabei leer und nicht mit Bauteilen zur Bestückung gerüstet.

Die Wechseltischsätze können hierbei jeweils an Positionen in einer zeitlichen Reihenfolge, in welcher die Wechseltischsätze im Vorrüstbereich gerüstet werden und in der gleichen zeitlichen Reihenfolge in der Produktion verwendet bzw. eingesetzt werden, zugeordnet werden.

Die Erfindung bringt den Vorteil mit sich, dass der Durchsatz in der Leiterplattenproduktion gesteigert werden kann. Es sind optimale Berechnungen für die oben genannte Reihenfolge möglich, wodurch unter anderem auch eine automatisierte Unterstützung in der Produktionsplanung erreicht wird.

Weiterhin sind die folgenden Verfahrensschritte vorgesehen:

- Erfassen eines oder mehrerer frühestmöglicher Zeitpunkte für den Beginn des Einsatzes eines Wechseltischsatzes,
- Erfassen eines frühestmöglichen Zeitpunkts für den Beginn der Produktion,
- Erfassen eines frühestmöglichen Zeitpunkts für den Beginn des Rüstens im Vorrüstbereich, und
- Optimierung der genannten Reihenfolge der Cluster unter Berücksichtigung der erfassten frühesten Zeitpunkte.

Damit kann die Wartezeit verringert werden, die dabei entsteht, dass für den Einsatz bzw. die Verwendung eines Wechseltischsatzes in der Produktion darauf gewartet werden muss, bis der Wechseltischsatz im Vorrüstbereich fertig gerüstet worden.

Eine Weiterbildung der Erfindung sieht eine Durchführung der Optimierung der Reihenfolge der Cluster mit Hilfe von Gemischt Ganzzahliger Linearer Optimierung vor.

Eine Weiterbildung der Erfindung sieht vor, dass unterschiedliche Typen von Rüstungen verwendet werden, wobei ein erster Typ einer Feströstung entspricht, die nach einem einmaligen Rüsten unverändert bleibt und vor der Produktion nicht ab- bzw. aufgerüstet wird. Pro Feströstung ist ein Wechseltischsatz vorgesehen. Ein zweiter Typ entspricht einer Variantenrüstung, die - wie eingangs erläutert - veränderbar ist. Für die Variantenrüstungen ist mindestens ein Wechseltischsatz vorgesehen. Jedes Cluster wird mit einer Rüstung eines vorgebbaren Typs der genannten Typen gefertigt bzw. produziert.

Eine Weiterbildung der Erfindung sieht vor, dass zusätzlich Umrüstzeiten erfasst und für die Optimierung berücksichtigt werden, die durch das Wechseln der Wechseltischsätze beim Übergang von einer Rüstung auf eine andere Rüstung auftreten. Um den Durchsatz zu verbessern, können in der Produktion zwischen die Cluster mit Variantenrüstungen geschickt eine oder mehrere Cluster mit Feströstungen dazwischen geschoben werden.

Eine Weiterbildung der Erfindung sieht vor, dass ein Cluster mit einer Feströstung aufgeteilt werden kann und mehrfach in die Reihenfolge der Cluster eingebracht werden kann.

Zudem kann ein Cluster mit einer Festrüstung zu Beginn und/oder am Ende in die Reihenfolge der Cluster eingebracht werden.

Ein weiterer Aspekt der Erfindung sieht eine Steuerungseinrichtung, eingerichtet zur Durchführung des Verfahren zur durchsatzoptimierten Produktion von Leiterplatten auf einer Bestückungslinie vor, wobei die Leiterplatten in Gruppen aufteilbar sind, die Cluster genannt werden, wobei ein Cluster jeweils mittels einer Rüstung gefertigt wird, wobei die Rüstung durch an der Bestückungslinie anbringbare Wechseltische realisierbar ist, die jeweils mindestens eine Zuführungseinrichtung zum Bereithalten von Vorräten von Bauelementen aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind,

- wobei eine Rüstung temporär auf leeren Wechseltischsätzen aufrüstbar und nach der Produktion von Leiterplatten durch deren Bestückung abrüstbar ist, und
- wobei einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,

  wobei die Steuereinheit folgende Erfassungseinrichtungen

  a) zum Erfassen einer Menge von Clustern,
  b) zum Erfassen einer Anzahl an leeren Wechseltischsätzen,
  c) zum Erfassen der jeweiligen Zeitdauer für das Erstellen der Rüstung für ein Cluster,
  d) zum Erfassen der jeweiligen Produktionszeitdauer für die Fertigung eines Clusters auf der Bestückungslinie,
  e) zum Auswählen einer Reihenfolge zur Verwendung der Wechseltischsätze zum Rüsten im Vorrüstbereich mit dem Ziel der Vermeidung von Wartezeiten in der Produktion, in welcher dieselben Wechseltischsätze zur Produktion der Leiterplatten einsetzbar sind, und
  f) Mittel zur Optimierung der Reihenfolge der Cluster unter Berücksichtigung der ausgewählten Reihenfolge zur Verwendung der Wechseltischsätze, so dass der Durchsatz auf der Bestückungslinie maximiert ist, sowie
  g) Mittel zur Durchführung der Produktion der Leiterplatten mit Hilfe der optimierten Reihenfolge der Cluster, aufweist.

Die Steuerungseinrichtung kann Mittel und/oder Einheiten bzw. Einrichtungen und/oder Module zur Durchführung des oben genannten Verfahrens vorsehen, die jeweils hardwaremäßig und/oder firmwaremäßig und/oder softwaremäßig bzw. als Computerprogramm bzw. Computerprogrammprodukt ausgeprägt sein können.

Die Steuerungseinrichtung kann wie das oben beschriebene Verfahren entsprechend weitergebildet werden.

Es ist auch ein Bestückungssystem möglich, das eine solche erfindungsgemäße Steuerungseinrichtung aufweist.

Dieses Bestückungssystem kann Teil einer Anlage sein.

Die Anlage kann unter anderem einer der folgenden Anlagentypen sein. Beispiele hierfür sind:

- eine Automatisierungsanlage oder
- eine Fertigungs- bzw. Produktionsanlage,

Ein weiterer Aspekt der Erfindung ist ein Computerprogrammprodukt bzw. ein Computerprogramm mit Mitteln zur Durchführung des oben genannten Verfahrens, wenn das Computerprogramm(-produkt) in einer oben genannten Steuerungseinrichtung oder in Mitteln der Vorrichtung zur Ausführung gebracht wird. Das Computerprogramm bzw. -produkt kann auf einem computerlesbaren Medium gespeichert sein. Das Computerprogramm bzw. - produkt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen. Diese Verarbeitungseinrichtung kann in der Steuerungseinrichtung oder in deren Mitteln integriert sein.

Weitere Vorteile, Einzelheiten und Weiterbildungen der Erfindung ergeben sich aus der nachfolgenden Beschreibung von Ausführungsbeispielen in Verbindung mit den Zeichnungen.

Es zeigen:

Fig. 1        ein Bestückungssystem;
Fig. 2        eine Graphik, die die Reihenfolge der Rüstvorgänge im Vorrüstbereich und die Reihenfolge der Verwendung der Rüstungen in der Produktion zeigt; und
Fig. 3 u. 4   je eine Graphik, die Einsatzmöglichkeiten der Wechseltischsätze zeigt, wobei Fig. 4 einen optimalen Einsatz der Wechseltischsätze ohne Wartezeiten in der Produktion zeigt.

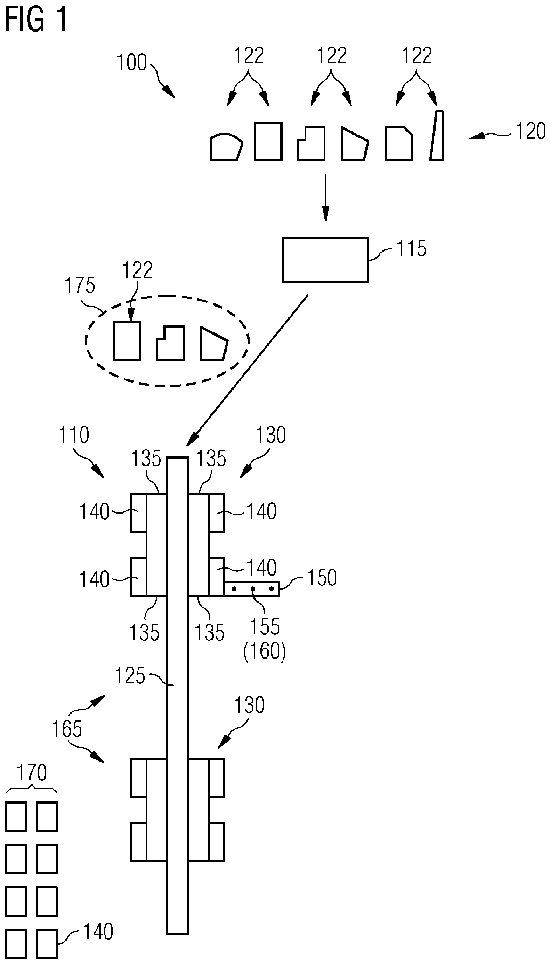

Figur 1 zeigt ein beispielhaftes Bestückungssystem 100. Das Bestückungssystem 100 umfasst eine oder mehrere Bestückungslinien 110 und eine Verarbeitungs- oder Steuerungseinrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 Bauelemente 155 aufzunehmen und an einen vorbestimmten Platz auf der Leiterplatte 120 zu positionieren, die sich auf dem Transportsystem 125 befindet. Während des Bestückungsvorgangs steht die Leiterplatte 120 bezüglich des Bestückungsautomaten 130 üblicherweise still.

Die Rüsttische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementtyps 160 bereit. Für die Bauelemente 155 hat die Zuführungseinrichtung 150 üblicherweise ein Fassungsvermögen, das in Spuren ausgedrückt werden kann. Eine Spur ist für gewöhnlich 8 mm breit und die Zahl der Spuren eines Rüsttischs 140 ist beschränkt, beispielsweise auf 40. Bauelemente 155 des gleichen Bauelementtyps 160 sind üblicherweise bereitgestellt in einem Gurt, auf einem Tablett oder in einer Röhre. Jeder Bauelementtyp 160 erfordert an der Zuführungseinrichtung 150 und am Rüsttisch 140 eine vorbestimmte Anzahl Spuren, die üblicherweise aneinander angrenzen.

Gewöhnlich kann eine Zuführungseinrichtung 150 zur Bereithaltung von Bauelementen 155 unterschiedlicher Bauelementtypen 160 konfiguriert werden und üblicherweise können unterschiedliche Zuführungseinrichtungen 150 an einem Rüsttisch 140 angebracht werden. Vorliegend wird vereinfachend davon ausgegangen, dass ein Vorrat von Bauelementen 155 eines Bauelementtyps 160 an einer Zuführungseinrichtung 150 praktisch unendlich groß ist, ein Nachrüsten also nicht erforderlich ist.

Wird am Bestückungsautomaten 130 ein Bauelement 155 eines Bauelementtyps 160 benötigt, der nicht an einem der Rüsttische 140 vorhanden ist, so wird üblicherweise nicht die Zuordnung von Bauelementen 155 an einem der angebrachten Rüsttische 140 verändert, sondern der Rüsttisch 140 wird komplett gegen einen anderen, passend bestückten Rüsttisch 140 ausgetauscht. Das Bestücken eines nicht an der Bestückungslinie 110 angebrachten Rüsttischs 140 mit Bauelementen 155 wird Vorrüstung genannt und kann eine Bearbeitungszeit im Bereich von einer oder mehreren Stunden, beispielsweise ca. 6-8 Stunden, erfordern.

Da ein Wechsel von Rüsttischen 140 an der Bestückungslinie 110, ein so genannter Rüstwechsel, üblicherweise mit einem Produktionsstillstand verbunden ist, wird angestrebt, Wechsel der Rüsttische 140 möglichst selten durchzuführen. Da ferner die Rüsttische 140 kostspielig sind und das Umrüsten eines Rüsttischs 140 aufwändig und langwierig sein kann, wird weiter versucht, möglichst wenige Rüstungen zu bilden, um eine vorbestimmte Produktionsmenge von Leiterplatten 120 vorbestimmter Leiterplattentypen 122 zu fertigen. Die Produktionsmenge umfasst hier mehrere Leiterplattentypen 122, von denen jeweils eine vorbestimmte Stückzahl Leiterplatten 120 mit Bauelementen 155 vorbestimmter Bauelementtypen 160 bestückt werden soll. Beispielsweise können 300 Leiterplatten 120 eines ersten Leiterplattentyps 122 und 200 Leiterplatten 120 eines zweiten Leiterplattentyps 122 bestückt werden.

Eine Rüstung 165, 170 umfasst eine Menge von Bauelementtypen 160 und wird realisiert durch einen oder mehrere Rüsttische 140, die bei mehreren Rüsttischen einen Wechseltischsatz bilden und jeweils mit Vorräten von Bauelementen 155 der Bauelementtypen 160 der Rüstung 165, 170 ausgestattet und an der Bestückungslinie 110 angebracht sind.

Der Rüstung 165, 170 ist eine Rüstfamilie 175 zugeordnet, die Leiterplattentypen 122 umfasst, von denen Leiterplatten 120 mittels Bauelementen 155 der Bauelementtypen 160 der Rüstung 165, 170 bestückt werden können. Eine Rüstfamilie 175 ist genau einer Rüstung 165, 170 zugeordnet und umgekehrt.

Um die Auslastung einer Bestückungslinie 110 zu erhöhen oder einen Bedarf an Rüsttischen 140 zu verringern ist es daher entscheidend, wie auf der Basis der zu bestückenden Leiterplattentypen 122 Rüstfamilien 175 gebildet werden. Bei der Bildung von Rüstungen 165, 170 bzw. Rüstfamilien 175 können Nebenbedingungen zu beachten sein, beispielsweise die Einhaltung einer begrenzten Fassungskapazität eines Rüsttisches 140 für Bauelementtypen 160 oder eine Gruppierung vorbestimmter Leiterplattentypen 160 in der gleichen Rüstfamilie 175, etwa aus Gründen der Verwendung bleihaltigen oder bleifreien Lötzinns.

Die Rüstungen können in Festrüstungen 165 und Variantenrüstungen 170 unterschieden werden, wobei eine Festrüstung 165 dazu vorgesehen ist, auf einer Anzahl Wechseltische 140 über einen vorbestimmten Planungszeitraum unverändert gerüstet zu bleiben, während ein Wechseltisch 140 einer Variantenrüstung 170 voraussichtlich innerhalb des Planungszeitraums mit Bauelementen 155 anderer Bauelementtypen 160 umgerüstet wird. Der Planungszeitraum kann beispielsweise 6 bis 12 Monate betragen. Eine Variantenrüstung 165 besteht in einer vorbestimmten Konstellation üblicherweise wesentlich kürzer als der Planungszeitraum, beispielsweise über mehrere Stunden oder Tage, üblicherweise jedoch nicht über mehr als eine Woche.

Die Rüstungen 165, 170 können nach Bedarf an der Bestückungslinie 110 ausgetauscht werden. Um eine Festrüstung 165 oder eine Variantenrüstung 170 zu realisieren wird üblicherweise ein Rüsttisch 140, während er nicht an der Bestückungslinie 110 angebracht ist, mit Vorräten von Bauelementen 155 vorbestimmter Bauelementtypen 160 aufgerüstet. Bereits aufgerüstete Bauelemente 155 nicht benötigter Bauelementtypen 160 können zuvor abgerüstet werden. Diese Umrüstung kann einen erheblichen Anteil manueller Arbeit umfassen und zeitaufwändig sein.

Um den mit einer Variantenrüstung 170 verbundenen Aufwand zu minimieren, wird versucht, in den Festrüstungen 165 möglichst viele Leiterplattentypen 122 aufzunehmen. Ein angestrebter Fall ohne Variantenrüstungen 170 ist in der Praxis jedoch kaum erzielbar.

Die Steuerungseinrichtung 115 ordnet im Rahmen der Steuerung des Bestückungssystems 100 Leiterplattentypen 122, deren zugeordnete Leiterplatten 120 auf der Bestückungslinie 110 bestückt werden sollen, jeweils einer Rüstfamilie 175 zu, wobei Festrüstungs-Rüstfamilien 175, die jeweils einer Festrüstung 165 zugeordnet ist, und Variantenrüstungs-Rüstfamilien 175, die jeweils einer Variantenrüstung 170 zugeordnet sind, gebildet werden können.

Ein Spezialfall von Optimierungsmethoden ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Ein sogenannter Solver (Löser) ist eine Sammelbezeichnung für spezielle mathematische Computerprogramme, die mathematische Probleme numerisch lösen können. Im Zusammenhang mit MILP (mixed integer linear programming bzw. gemischt ganzzahlige Lineare Programmierung) können für kleine IP-Programme (ganzzahlige Optimierungsmodelle) Standardsolver wie z.B. CPLEX, Scip, Gurobi, Xpress verwendet werden.

Im Folgenden wird ein Beispiel beschrieben, in dem mittels eines MILP-Modell (Mixed Integer Linear Programming) optimale zeitliche Rüstreihenfolgen von vorgegebenen zu fertigenden variablen Rüstfamilien berechnet werden. Zudem kann eine optimale zeitliche Reihenfolge für den Einsatz der gerüsteten Wechseltischsätze (Variantenrüstung) und gegebenenfalls der Festrüstungswechseltischsätze an der Bestückungslinie berechnet werden.

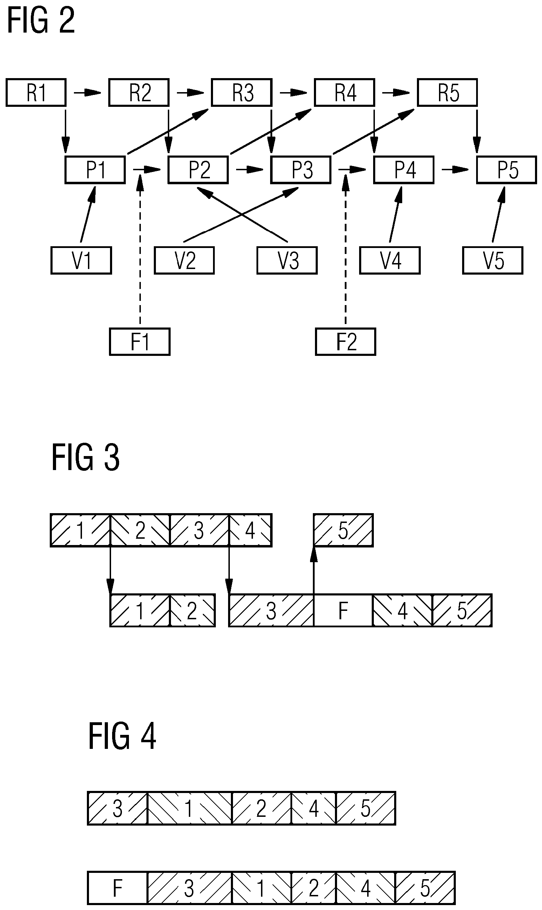

In der Figur 2 ist schematisch folgendes dargestellt:

In der ersten Reihe werden Positionen in einer bestimmten zeitlichen Reihenfolge gezeigt, im folgenden auch Rüstpositionen genannt. Die Cluster mit variablen bzw.

Varianten-Rüstungen R1, R2, R3, R4, R5 usw. werden dabei den Positionen innerhalb der Rüstreihenfolge (Variantenrüstungsreihenfolge) zugewiesen. Gibt es wie im Beispiel 5 Cluster mit variablen Rüstungen, so gibt es auch 5 Positionen (1,2,3, und 5) innerhalb der Rüstreihenfolge, auf die die Cluster mit variablen Rüstungen (eineindeutig) zugewiesen werden. Für die Erstellung dieser Cluster mit variablen Rüstungen steht eine gewisse Anzahl an Wechseltischsätzen zur Verfügung.

Gewöhnlich gibt es zwei solche Wechseltischsätze. Einer der beiden Wechseltischsätze steht gerüstet an der Bestückungslinie zur Verfügung. Der andere der beiden Wechseltischsätze befindet sich im Vorrüstbereich. Vorab werden den Positionen abwechselnd die Wechseltischsätze zugeordnet, wobei bei der Zuordnung mit dem Wechseltischsatz begonnen wird, der zum frühesten Zeitpunkt zur Verfügung steht.

In der zweiten Reihe der Figur 2 wird die Reihenfolge mit Positionen P1, P2, P3, P4, P5 usw. , im folgenden Produktionspositionen genannt, an der Bestückunglinie zur Produktion der Leiterplatten gezeigt, wobei die Wechseltischsätze in der gleichen zeitlichen Reihenfolge in der Produktion eingesetzt werden, in welcher sie fertig gerüstet worden sind. In der Figur 2 wird durch die Pfeile zwischen der ersten und zweiten Reihe angedeutet, welche Wartebeziehungen es zwischen den Positionen 1 bis 5 gibt. Mit anderen Worten ausgedrückt ein Wechseltischsatz muss z.B. an Position R1 erst fertig gerüstet sein, bevor er an Position P1 in der Produktion verwendet werden kann.

In der dritten Reihe von Figur 2 sind Cluster mit Variantenrüstungen V1 bis V5 dargestellt. Die Pfeile zwischen der zweiten und der dritten Reihe deuten Zuordnungen von Cluster mit Variantenrüstungen zu den Positionen P1 bis P5 an. Es kann sinnvoll sein, z.B. das Cluster mit Variantenrüstung V3 an P2 und das Cluster mit Variantenrüstung V2 an P3 zu positionieren, wenn die Rüstzeit(dauer) für V3 kürzer ist als für V2. Somit würden unnötige Wartezeiten bzw. Stillstandszeiten in der Produktion vermieden werden.

Des weiteren sind in der vierten Reihe von Figur 2 Cluster mit Festrüstungen F1 und F2 gezeigt, die - wie bereits oben beschrieben - jeweils auf zwei Wechseltischsätzen fest gerüstet sind. Es entstehen für die Cluster mit Festrüstungen daher keine Wartezeiten, da die Festrüstungen nur einmal aufgerüstet werden und dann dafür einen längeren (Planungs-)Zeitraum beibehalten werden. Die gestrichelten Pfeile zwischen der vierten und zweiten Reihe deuten an, dass Cluster mit Festrüstungen in die Produktionsreihenfolge an "Zwischenpositionen" eingeschoben bzw. dazwischen geschoben werden können. Dies bringt den Vorteil mit sich, dass auf diese Weise Wartezeiten in der Produktion auf die Fertigstellung der benötigten Variantenrüstungen vermieden werden können.

In der Formulierung des MILP-Modells gelten die folgenden Bezeichnungen:

Indices:

*R*    Menge der zu fertigzustellenden Rüstungen/ zu produzierenden Cluster

*F*      Menge der Cluster mit Festrüstungen (F ⊂ R)
*V*      Menge der Cluster mit variablen Rüstungen *(V ⊂ R)*
*P*      Menge der Reihenfolge-Positionen für die Cluster mit variablen Rüstungen, *P* = {1,...,|*V*|}
*T*      Menge der leeren Wechseltischsätze für die Variantenrüstungen
$P_S$     Aufsteigend sortierte Menge an Positionen, an denen Wechseltischsatz s∈T verwendet wird.

Parameter:

PTime$_r$          Produktionszeitdauer von Cluster r inklusive der Umrüstzeit an der Bestückungslinie
RTime$_r$          Rüstungszeitdauer für die Erstellung der Rüstung von Cluster r
EarliestBegin$_L$    Frühestmöglicher Beginn der Produktion an der Bestückungslinie
EarliestBegin$_R$    Frühestmöglicher Beginn des Rüstens im Vorrüstbereich
EarliestBegin$_s$    Frühestmöglicher Einsatz für Wechseltischsatz s

Binärvariablen:

assign$_{v,p}$     Variable, die angibt, ob das Cluster mit variabler Rüstung v an p-ter Position der Produktionsreihenfolge für die Cluster mit variablen Rüstungen eingesetzt wird. (In diesem Fall nimmt sie den Wert 1, anderenfalls den Wert 0 an)
assignBefore$_{f,p}$     Variable, die angibt an welcher Zwischenposition ein Cluster mit Festrüstung f eingesetzt wird, d.h - für p = 1, ob das Cluster f vor dem ersten Cluster mit einer Variantenrüstung eingesetzt wird, - für 2≤p≤|P|, ob f vor der p-ten Cluster mit einer Variantenrüstung und nach dem (p-1)-ten Cluster mit einer Variantenrüstung eingesetzt wird. - und für p = |P|+1, ob das Cluster mit Festrüstung nach dem letzten Cluster mit Variantenrüstung eingesetzt wird. (In den jeweiligen Fällen nimmt sie den Wert 1, anderenfalls den Wert 0 an)

$begin_p^L$          Beginn der Fertigung bzw. Produktion mit dem Cluster an p-ter Position der Variantenrüstungsreihenfolge

$begin_p^V$          Beginn der Rüsterstellung der Rüstung für das Cluster an p-ter Position der Variantenrüstungsreihenfolge im Vorrüstbereich

$end_p^L$          Ende der Fertigung des Clusters an p-ter Position der Variantenrüstungsreihenfolge

$end_p^V$          Ende der Rüsterstellung der Rüstung für das Cluster an p-ter Position der Variantenrüstungsreihenfolge im Vorrüstbereich

*t*      Endzeitpunkt der Fertigstellung aller Rüstungen

IP-Formulierung:

Zielfunktion:

Minimiere *t*

Nebenbedingungen:

(1) Jedes Cluster mit Variantenrüstung muss einer Position zugeordnet sein.

$$\sum_{p \in P} \text{assign}_{v,p} = 1, \qquad v \in V$$

(2) Jeder Position muss ein ein Cluster mit Variantenrüstung zugewiesen sein.   $\sum_{v \in V} \text{assign}_{v,p} = 1$ $p \in P$

(3) Jedes Cluster mit Festrüstung muss einer Zwischenposition zugewiesen sein.

$$\sum_{p=1}^{|P|+1} \text{assignBefore}_{v,p} = 1 \qquad f \in F$$

(4) Die Produktion eines Clusters mit einer Variantenrüstung an
Position p kann erst beginnen, wenn die Rüstung im Vorrüstbereich erstellt ist.

$$end_p^V \leq begin_p^L \qquad p \in P$$

(5) Der Rüstvorgang einer Variantenrüstung für das Cluster an Position p kann erst beginnen, wenn der Rüstvorgang der Variantenrüstung für das Cluster an der Position p-1 abgeschlossen ist.

$$end_{p-1}^V \leq begin_p^V \qquad p = 2, \dots, |P|$$

(6) Der Rüstvorgang für die Variantenrüstung für das Cluster an der Position p kann im Vorrüstbereich erst beginnen, wenn der zugewiesene Wechseltischsatz frei bzw.
leer ist.

$$end_{p'}^L \leq begin_p^V \qquad p \text{ direkter Nachfolger von } p' \text{ in } P_s, s \in T$$

(7) Berücksichtigung der Produktionszeiten der Cluster mit Variantenrüstungen

$$end_p^L = begin_p^L + \sum_{p \in P} \text{PTime}_v \; assign_{v,p} \qquad v \in V$$

(8) Berücksichtigung der Rüstzeiten der Cluster mit Variantenrüstungen im Vorrüstbereich

$$end_p^V = begin_p^V + \sum_{p \in P} \text{RTime}_v \; assign_{v,p} \qquad v \in V$$

(9) Die Produktion mit eines Clusters mit Variantenrüstung an
Position p kann erst beginnen, wenn die Produktion des Clusters mit Variantenrüstung an der Position p-1 und die Produktion eines Clusters mit Festrüstung zwischen p-1 und p abgeschlossen sind

$$end_{p-1}^L + \sum_{f \in F} \text{PTime}_f \; assignBefore_{f,p} \leq begin_p^L \qquad p = 2, \dots, |P|$$

(10) Die Produktion an der Bestückungslinie kann initial erst beginnen, wenn die Bestückungslinie dafür verfügbar ist.

$$EarliestBegin_L + \sum_{f \in F} \text{PTime}_f \; assignBefore_{f,0} \leq begin_1^L$$

(11) Die Rüsterstellung im Vorrüstbereich kann initial erst beginnen, wenn der Vorrüstbereich dafür verfügbar ist.

$$EarliestBegin_V \; \le \; begin_1^V$$

(12) Die Rüsterstellung im Vorrüstbereich für die erste Rüstung mit Wechseltischsatz s kann erst beginnen, wenn der Wechseltischsatz s dafür verfügbar ist.

$$EarliestBegin_s \; \le \; begin_p^V \qquad\qquad p \; erstes \; Element \; in \; P_s$$

(13) Die Fertigstellung aller Rüstungen ist erst erfolgt, wenn das letzte Cluster mit Variantenrüstung fertig ist und die nachfolgenden Cluster mit Festrüstungen ebenfalls fertig sind.

$$t \; \ge \; end_{|P|}^L + \sum_{f \in F} \mathrm{PTime_f} \; assignBefore_{f,|P|+1}$$

(14) Variablenrestriktionen

$$\mathrm{assign_{v,p}} \in \{0,1\} \qquad v \in V, p \in P$$

$$\mathrm{assignBefore_{f,p}} \in \{0,1\} \qquad f \in F, p = 1, \dots, |P| + 1$$

$$begin_p^L \ge 0 \qquad p \in P$$

$$begin_p^V \ge 0 \qquad p \in P$$

$$end_p^L \ge 0 \qquad p \in P$$

$$end_p^V \ge 0 \qquad p \in P$$

$$t \ge 0$$

Es sind folgende Weiterbildungen möglich:

a) Berücksichtigung von "nicht vorhandenen" Umrüstzeiten:
Ist das zuletzt vor dem Planungszeitraum fertiggestellte Cluster ein Cluster mit Festrüstung f' und muss ein Cluster mit dieser Festrüstung im Planungszeitraum ebenfalls fertiggestellt werden, so lässt sich die Umrüstzeit für diese Festrüstung einsparen, wenn sie als Erstes fertiggestellt wird.
Die Umrüstzeit von f' betrage UmruestT f'. Im MILP ist nun die Restriktion (10) mit der nachfolgenden Restriktion zu ersetzen:

$$EarliestBegin_L \; - \; \mathrm{UmruestT}_{f'} \; assignBefore_{f',1}$$
$$+ \sum_{f \in F} \mathrm{PTime_f} \; assignBefore_{f,0} \; \le \; begin_1^L$$

b) Bevorzugt ist, Cluster mit Festrüstung am Schluss fertigzustellen:
Aus dem in (1) beschriebenen Grund ist es zudem günstig, ein Cluster mit einer Festrüstung am Ende fertigzustellen. Dazu kann folgende Zielfunktions-Komponente mit einer kleinen Gewichtung mit in die Minimierungs-Zielfunktion aufgenommen werden:

$$-\sum_{f\in F} assignBefore_{f,|P|+1}$$

c) Mögliche Teilung eines Clusters mit einer Festrüstung:
Treten in der optimalen Lösung des Modells Wartezeiten auf, so lassen sich diese in der Regel dadurch vermeiden, wenn man zulässt, dass ein Cluster mit einer Festrüstung nicht in einem Stück fertiggestellt wird, sondern in mehrere Teile aufgeteilt werden kann, die dann jeweils als Puffer zwischen Cluster mit Variantenrüstungen eingesetzt werden können. Für jeden Teil fällt dann eine entsprechende Umrüstzeit an.

Im Folgenden werden deshalb die Umrüstzeiten (Zeiten für das Wechseln der Tischsätze) der Festrüstungen separat modelliert und sind nicht in den Produktionszeiten $ProdT_f$ enthalten.

$SetupT_f$    Zeit für das einmalige Umrüsten auf ein Cluster mit Festrüstung f

Zudem werden folgende nicht negative, kontinuierliche Variablen benötigt:

$prodTime_{f,p}$        Zeit zur Fertigstellung des Clusters mit

Festrüstung f    vor dem p-ten Cluster mit Variantenrüstung

Die Nebenbedingungen aus (3) werden dann gestrichen, da es nun erlaubt ist ein Cluster mit Festrüstung zu teilen.

Zusätzlich benötigt man nun folgende Nebenbedingungen:

(15) Die Produktionszeiten für Teilcluster mit Festrüstung f müssen in Summe genau der Produktionszeit von f entsprechen.

$$\sum_{p=1}^{|P|+1} prodTime_{f,p} = PTime_f \qquad f \in F$$

(16) Nur, wenn ein Cluster mit Festrüstung einem Zwischenzeitraum zugewiesen ist, darf in diesem Zeitraum auch ein Teil davon produziert werden.

$$PTime_f\ assignBefore_{f,p}\ \geq\ prodTime_{f,p} \qquad f \in F, p = 1, ..., |P| + 1$$

(17) Die Nebenbedingen aus (9) werden durch die folgenden Nebenbedingungen ersetzt, da die Umrüstzeiten nun explizit berücksichtigt werden.

$$end_{p-1}^{L} + \sum_{f\in F}(SetupT_f\ assignBefore_{f,p} + prodTime_{f,p}) \leq begin_p^L$$

$$p = 1, ..., |P| + 1$$

(18) Die Nebenbedingung (10) werden durch folgende Nebenbedingungen ersetzt:

$$EarliestBegin_L + \sum_{f \in F}(\text{SetupT}_f \quad assignBefore_{f,0} + \text{prodTime}_{f,0})$$
$$\leq begin_1^L$$

(19) Die Nebenbedingung (13) wird durch folgende Nebenbedingung ersetzt:

$$t \geq end_{|P|}^L + \sum_{f \in F}(\text{SetupT}_f \quad assignBefore_{f,|P|+1} + \text{prodTime}_{f,|P|+1})$$

In einem weiteren Beispiel gemäß der Figuren 3 und 4 sollen auf einer Bestückungslinie fünf Cluster mit Variantenrüstungen (V1 bis V5) sowie ein Cluster mit Feströstung F fertiggestellt werden. Für die Fertigstellung der Cluster mit Variantenrüstungen stehen zwei Wechseltischsätze zur Verfügung. Die frühestmöglichen Zeitpunkte für den Beginn des Rüstens, den Beginn der Produktion und für den Einsatz der Wechseltischsätze seien alle auf 0 gesetzt.
Die Rüstzeiten und die Produktionszeiten im Beispiel können der folgenden Tabelle entnommen werden:

| Rüstungen | Rüstzeit in ZE | Produktionszeit in ZE |
|---|---|---|
| V1 | 3 | 2 |
| V2 | 2 | 1 |
| V3 | 2 | 3 |
| V4 | 1 | 2 |
| V5 | 2 | 2 |
| F | | 2 |

Eine mögliche Rüst- und Produktionsreihenfolge 1, 2, 3, 4, 5 ist in der Figur 3 dargestellt.
Es wird begonnen mit dem Rüsten (siehe erste Reihe in Figur 3) der Rüstung V1 auf dem ersten Wechseltischsatz, welcher mit einer Schraffur nach rechts angedeutet ist. Erst wenn die Rüstung fertig ist, kann in der Produktion mit V1 an Position 2 begonnen werden (siehe zweite Reihe in Figur 3). An der Produktionslinie entsteht deshalb eine Stillstandzeit von 3 Zeiteinheiten (ZE).
Parallel zur Produktion mit V1 wird bereits die Rüstung V2 auf einem zweiten Tischsatz gerüstet, welcher mit einer Schraffur nach links angedeutet ist. Die Produktion mit V2 kann unverzüglich nach der Produktion von V1 beginnen, da die Rüstung von V2 rechtzeitig fertig wird.
Die Rüstung von V3 wird wieder parallel zur Produktion mit V2 erstellt. Die Produktionslaufzeit von V2 ist allerdings kürzer als die Rüsterstellung von V3 und somit entsteht vor dem Produktionsbeginn mit V3 wieder eine Stillstandzeit an der Linie.
Die gesamte Durchlaufzeit beträgt 16 Zeiteinheiten.
Eine optimale Rüst- und Produktionsreihenfolge ist in Figur 4 gezeigt. Hierbei beträgt die gesamte Durchlaufzeit nur noch 12 Zeiteinheiten.
Durch Minimierung der Durchlaufzeit kann der Durchsatz an einer Bestückungslinie verbessert bzw. optimiert werden. Letztendlich wird die Produktion der Leiterplatten mit Hilfe der oben optimierten Reihenfolge durchgeführt.
Das obige Beispiel ist ein vereinfachtes Modell. In der Realität sind die Optimierungsprobleme komplexer. Um komplexe Optimierungsprobleme zu lösen, können solche MILP-Modelle der oben erläuterten Art eingesetzt werden.
Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Ansprüche zu verlassen.
Die Implementierung der vorstehend beschriebenen Prozesse oder Verfahrensabläufe kann anhand von Instruktionen erfolgen, die auf computerlesbaren Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.
Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System abzulegen und darauf via Netzwerk zuzugreifen.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein.

**Patentansprüche**

1.  Verfahren zur durchsatzoptimierten Produktion von Leiterplatten (120) auf einer Bestückungslinie (110), wobei die Leiterplatten in Gruppen aufgeteilt sind, die Cluster genannt werden, wobei ein Cluster (175) jeweils mittels einer Rüstung gefertigt wird, wobei die Rüstung durch an der Bestückungslinie anbringbare Wechseltische (140) realisiert wird, die jeweils mindestens eine Zuführungseinrichtung (150) zum Bereithalten von Vorräten von Bauelementen (155) aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind,

    - wobei eine Rüstung temporär auf leeren Wechseltischsätzen aufgerüstet und nach der Produktion von Leiterplatten durch deren Bestückung abgerüstet wird, und
    - wobei einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,
    wobei das Verfahren folgende Schritte umfasst:

        a) Erfassen einer Menge von Clustern,
        b) Erfassen einer Anzahl an leeren Wechseltischsätzen,
        c) Erfassen der jeweiligen Zeitdauer für das Erstellen der Rüstung für ein Cluster,
        d) Erfassen der jeweiligen Produktionszeitdauer für die Fertigung eines Clusters auf der Bestückungslinie,
        e) Auswählen einer Rüstreihenfolge, in welcher die Wechseltischsätze im Vorrüstbereich gerüstet werden, mit dem Ziel der Vermeidung von Wartezeiten in der Produktion, in welcher dieselben Wechseltischsätze zur Produktion der Leiterplatten eingesetzt werden,
        f) Optimierung der zeitlichen Reihenfolge der Cluster unter Berücksichtigung der ausgewählten Rüstreihenfolge, so dass der Durchsatz auf der Bestückungslinie maximiert wird,
        g) Durchführung der Produktion der Leiterplatten mit Hilfe der optimierten zeitlichen Reihenfolge der Cluster, wobei

    des weiteren folgende Schritte durchgeführt werden:

        - Erfassen eines oder mehrerer frühestmöglichen Zeitpunkte für den Beginn des Einsatzes eines Wechseltischsatz,
        - Erfassen eines frühestmöglichen Zeitpunkts für den Beginn der Produktion
        - Erfassen eines frühestmöglichen Zeitpunkts für den Beginn des Rüstens im Vorrüstbereich, und
        - Optimierung der genannten Reihenfolge der Cluster unter Berücksichtigung der erfassten frühesten Zeitpunkte.

2.  Verfahren nach einem der vorhergehenden Ansprüche,
    **dadurch gekennzeichnet, dass** die Optimierung der Reihenfolge der Cluster mit Hilfe von Gemischt Ganzzahliger Linearer Optimierung durchgeführt wird.

3.  Verfahren nach einem der vorhergehenden Ansprüche,

**dadurch gekennzeichnet, dass** unterschiedliche Typen von Rüstungen verwendet werden, wobei ein erster Typ einer Festrüstung (F1, F2) entspricht, die nach einem einmaligen Rüsten unverändert bleibt und vor der Produktion nicht ab- und aufgerüstet wird sowie pro Festrüstung ein Wechseltischsatz vorgesehen ist, wobei ein zweiter Typ einer Variantenrüstung (V1, V2, V3, V4, V5) entspricht, die gemäß der vorhergehenden Ansprüche veränderbar ist und für die Variantenrüstungen mindestens ein Wechseltischsatz vorgesehen ist und wobei jedes Cluster mit einer Rüstung eines vorgebbaren Typs der genannten Typen gefertigt wird.

4. Verfahren nach einem vorhergehenden Anspruch, **dadurch gekennzeichnet, dass** zusätzlich Umrüstzeiten erfasst und für die Optimierung berücksichtigt werden, die durch das Wechseln der Wechseltischsätze beim Übergang von einer Rüstung auf eine andere Rüstung auftreten.

5. Verfahren nach dem vorhergehenden Anspruch, **dadurch gekennzeichnet, dass** ein Cluster mit einer Festrüstung aufgeteilt werden kann und mehrfach in die Reihenfolge der Cluster eingebracht werden kann.

6. Steuerungseinrichtung eingerichtet zur Durchführung des Verfahren zur durchsatzoptimierten Produktion von Leiterplatten (120) auf einer Bestückungslinie (110) nach einem der vorhergehenden Ansprüche, wobei die Leiterplatten in Gruppen aufteilbar sind, die Cluster (175) genannt werden, wobei ein Cluster jeweils mittels einer Rüstung gefertigt wird, wobei die Rüstung durch an der Bestückungslinie anbringbare Wechseltische (140) realisierbar ist, die jeweils mindestens eine Zuführungseinrichtung (150) zum Bereithalten von Vorräten von Bauelementen (155) aufweisen, wobei eine Menge von pro Rüstung notwendigen Wechseltischen als Wechseltischsatz bezeichnet wird und ein leerer Wechseltischsatz Wechseltische aufweist, deren Zuführungseinrichtungen leer sind,

- wobei eine Rüstung temporär auf leeren Wechseltischsätzen aufrüstbar und nach der Produktion von Leiterplatten durch deren Bestückung abrüstbar ist, und
- wobei einer der Wechseltischsätze erst dann in der Produktion einsetzbar ist, wenn er vollständig in einem Vorrüstbereich aufgerüstet worden ist, und der Wechseltischsatz erst dann wieder aufrüstbar ist, wenn die mit dem Wechseltischsatz durchgeführte Produktion beendet und der Wechseltischsatz im Vorrüstbereich wieder abgerüstet worden ist,
wobei die Steuereinheit folgende Erfassungseinrichtungen

a) zum Erfassen einer Menge von Clustern,
b) zum Erfassen einer Anzahl an leeren Wechseltischsätzen,
c) zum Erfassen der jeweiligen Zeitdauer für das Erstellen der Rüstung für ein Cluster,
d) zum Erfassen der jeweiligen Produktionszeitdauer für die Fertigung eines Clusters auf der Bestückungslinie,
e) zum Auswählen einer Rüstreihenfolge, in welcher die Wechseltischsätze im Vorrüstbereich gerüstet werden können, mit dem Ziel der Vermeidung von Wartezeiten in der Produktion, in welcher dieselben Wechseltischsätze zur Produktion der Leiterplatten einsetzbar sind, und
f) Mittel zur Optimierung der zeitlichen Reihenfolge der Cluster unter Berücksichtigung der ausgewählten Rüstreihenfolge, so dass der Durchsatz auf der Bestückungslinie maximiert ist, sowie
g) Mittel zur Durchführung der Produktion der Leiterplatten mit Hilfe der optimierten zeitlichen Reihenfolge der Cluster, und
des weiteren folgende Mittel

- zum Erfassen eines oder mehrerer frühestmöglichen Zeitpunkte für den Beginn des Einsatzes eines Wechseltischsatz,
- zum Erfassen eines frühestmöglichen Zeitpunkts für den Beginn der Produktion
- zum Erfassen eines frühestmöglichen Zeitpunkts für den Beginn des Rüstens im Vorrüstbereich, und
- zum Optimierung der genannten Reihenfolge der Cluster unter Berücksichtigung der erfassten frühesten Zeitpunkte, aufweist.

7. Computerprogrammprodukt mit Programmcodemitteln zur Durchführung des Verfahrens nach einem der vorangehenden Ansprüche, wenn es auf einer Steuerungseinrichtung nach dem vorangehenden Anspruch abläuft.

**Claims**

1. Method for throughput-optimized production of printed circuit boards (120) on a pick-and-place line (110), wherein the printed circuit boards are divided into groups known as clusters, wherein each cluster (175) is produced by means of a setup, wherein the setup is realized by means of changing tables (140) that can be attached to the pick-and-place line, which changing tables each have at least one feed device (150) for holding in readiness stocks of components (155), wherein a quantity of changing tables needed for each setup is designated as a changing table set and an empty changing table set comprises changing tables whose feed devices are empty,

- wherein a setup is set up temporarily on empty changing table sets and after production of printed circuit boards is removed as a result of the picking and placing thereof, and
- wherein one of the changing table sets can only be put into production when it has been completely set up in a pre-setup region and the changing table set can then only be set up again when the production performed with the changing table set has ended and the changing table set has been removed again in the pre-setup region, wherein the method comprises the following steps:

a) recording a quantity of clusters,
b) recording a number of empty changing table sets,
c) recording the respective time duration for the creation of the setup for a cluster,
d) recording the respective production time duration for the fabrication of a cluster on the pick-and-place line,
e) selecting a setup sequence, in which the changing table sets are set up in the pre-setup region, with the aim of avoiding waiting times in production in which the same changing table sets are used for the production of printed circuit boards,
f) optimizing the time sequence of the clusters taking into account the selected setup sequence so that the throughput on the pick-and-place line is maximized,
g) carrying out the production of the printed circuit boards with the aid of the optimized time sequence of clusters,

wherein
furthermore the following steps are carried out:

- recording one or more earliest possible time points for the beginning of the use of a changing table set,
- recording an earliest possible time point for the beginning of production
- recording an earliest possible time point for the beginning of setting up in the pre-setup region, and
- optimizing the said sequence of clusters taking into account the recorded earliest time points.

2. Method according to one of the preceding claims, **characterized in that** the optimization of the sequence of clusters is performed with the aid of mixed integer linear optimization.

3. Method according to one of the preceding claims, **characterized in that** different types of setups are used, wherein a first type corresponds to a fixed setup (F1, F2), which remains unchanged after a single setting up and is not removed and set up prior to production, and one changing table set is provided per fixed setup, wherein a second type corresponds to a variant setup (V1, V2, V3, V4, V5) that can be varied according to the preceding claims and at least one changing table set is provided for the variant setups and wherein each cluster is fabricated with a setup of a predefinable type of the said types.

4. Method according to a preceding claim, **characterized in that**, in addition, refitting times are recorded and taken into account for the optimization, which refitting times occur due to the changing of the changing table sets on transition from one setup to another setup.

5. Method according to the preceding claim, **characterized in that** a cluster with a fixed setup can be divided and can be introduced multiple times into the sequence of clusters.

6. Control device, adapted for carrying out the method for throughput-optimized production of printed circuit boards (120) on a pick-and-place line (110) according to one of the preceding claims, wherein the printed circuit boards can be divided into groups known as clusters (175), wherein each cluster is produced by means of a setup, wherein the setup can be realized by means of changing tables (140) that can be attached to the pick-and-place line, which changing tables each have at least one feed device (150) for holding in readiness stocks of components (155), wherein a quantity of changing tables needed for each setup is designated as a changing table set and an empty changing table set comprises changing tables whose feed devices are empty,

- wherein a setup can be set up temporarily on empty changing table sets and after production of printed circuit boards can be removed as a result of the picking and placing thereof, and

- wherein one of the changing table sets can only be put into production when it has been completely set up in a pre-setup region and the changing table set can then only be set up again when the production performed with the changing table set has ended and the changing table set has been removed again in the pre-setup region, wherein the control unit comprises the following recording devices

a) for recording a quantity of clusters,

b) for recording a number of empty changing table sets,

c) for recording the respective time duration for the creation of the setup for a cluster,

d) for recording the respective production time duration for the fabrication of a cluster on the pick-and-place line,

e) for selecting a setup sequence, in which the changing table sets are set up in the pre-setup region, with the aim of avoiding waiting times in production in which the same changing table sets can be used for the production of printed circuit boards, and

f) means for optimizing the time sequence of the clusters taking into account the selected setup sequence so that the throughput on the pick-and-place line is maximized, as well as

g) means for carrying out the production of the printed circuit boards with the aid of the optimized time sequence of clusters,

and

furthermore has the following means

- for recording one or more earliest possible time points for the beginning of the use of a changing table set,
- for recording an earliest possible time point for the beginning of production
- for recording an earliest possible time point for the beginning of setting up in the pre-setup region, and
- for optimizing the said sequence of clusters taking into account the recorded earliest time points.

7. Computer program product with program code means for carrying out the method according to one of the preceding claims, when it is running on a control device according to the preceding claim.

**Revendications**

1. Procédé pour la production à rendement optimisé de cartes de circuits imprimés (120) sur une ligne de montage (110), les circuits imprimés étant répartis en groupes appelés clusters, un cluster (175) étant fabriqué respectivement au moyen d'une armature, l'armature étant réalisée par des tables de changement (140) pouvant être montées sur la ligne de montage et comportant respectivement au moins un dispositif d'alimentation (150) pour tenir à disposition des réserves de composants (155), une quantité de tables de changement nécessaires pour chaque armature étant appelée jeu de tables de changement et un jeu de tables de changement vide présentant des tables de changement dont les dispositifs d'alimentation sont vides,

- une armature étant équipée temporairement sur des jeux de tables de changement vides et déséquipée après la production de circuits imprimés du fait de leur équipement et

- l'un des jeux de tables de changement ne pouvant être utilisé dans la production que s'il a été entièrement équipé dans une zone de pré-équipement et le jeu de tables de changement ne pouvant être de nouveau équipé que si la production effectuée avec le jeu de tables de changement est terminée et le jeu de tables de changement a de nouveau été déséquipé dans la zone de pré-équipement,

le procédé comprenant les étapes suivantes :

a) détection d'une quantité de clusters,

b) détection d'un nombre de jeux de tables de changement vides,

c) détection de la durée respective pour la réalisation de l'armature pour un cluster,

d) détection de la durée de production respective pour la fabrication d'un cluster sur la ligne de montage,

e) sélection d'un ordre d'équipement dans lequel les jeux de tables de changement sont équipés dans la zone de pré-équipement dans le but d'éviter des temps d'attente dans la production dans laquelle les mêmes jeux de tables de changement sont utilisés pour la production des circuits imprimés,

f) optimisation de l'ordre chronologique des clusters compte tenu de l'ordre d'équipement sélectionné, de sorte que le rendement sur la ligne de montage est maximisé,

g) exécution de la production des circuits imprimés à l'aide de l'ordre chronologique optimisé des clusters,

les étapes suivantes étant en outre exécutées :

- détection d'un ou de plusieurs instants les plus précoces possibles pour le début de l'utilisation d'un jeu de tables de changement,
- détection d'un instant le plus précoce possible pour le début de la production,
- détection d'un instant le plus précoce possible pour le début de l'équipement dans la zone de pré-équipement et
- optimisation de l'ordre des clusters compte tenu des instants les plus précoces détectés.

**2.** Procédé selon l'une des revendications précédentes, **caractérisé en ce que** l'optimisation de l'ordre des clusters est effectuée à l'aide d'une optimisation linéaire entière mixte.

**3.** Procédé selon l'une des revendications précédentes, **caractérisé en ce que** sont utilisés différents types d'armatures, un premier type correspondant à une armature fixe (F1, F2) qui reste inchangée après un premier équipement et qui n'est pas déséquipée et équipée avant la production et un jeu de tables de changement étant prévu pour chaque armature fixe, un deuxième type correspondant à une armature variable (V1, V2, V3, V4, V5) qui peut être modifiée selon les revendications précédentes et au moins un jeu de tables de changement étant prévu pour les armatures variables et chaque cluster étant fabriqué avec une armature d'un type prédéfinissable desdits types.

**4.** Procédé selon une revendication précédente, **caractérisé en ce que** sont en outre détectés et pris en compte pour l'optimisation des temps de rééquipement qui surviennent du fait du changement des jeux de tables de changement lors du passage d'une armature à une autre.

**5.** Procédé selon la revendication précédente, **caractérisé en ce qu'**un cluster avec armature fixe peut être réparti et inséré plusieurs fois dans l'ordre des clusters.

**6.** Dispositif de commande configuré pour exécuter le procédé pour la production de circuits imprimés (120) à rendement optimisé sur une ligne de montage (110) selon l'une des revendications précédentes, les circuits imprimés pouvant être répartis en groupes appelés clusters (175), un cluster étant fabriqué respectivement au moyen d'une armature, l'armature pouvant être réalisée par des tables de changement (140) pouvant être montées sur la ligne de montage et comportant respectivement au moins un dispositif d'alimentation (150) pour tenir à disposition des réserves de composants (155), une quantité de tables de changement nécessaires pour chaque armature étant appelée jeu de tables de changement et un jeu de tables de changement vide présentant des tables de changement dont les dispositifs d'alimentation sont vides,

- une armature pouvant être équipée temporairement sur des jeux de tables de changement vides et déséquipée après la production de circuits imprimés du fait de leur équipement et
- l'un des jeux de tables de changement ne pouvant être utilisé dans la production que s'il a été entièrement équipé dans une zone de pré-équipement et le jeu de tables de changement ne pouvant être de nouveau équipé que si la production effectuée avec le jeu de tables de changement est terminée et le jeu de tables de changement a de nouveau été déséquipé dans la zone de pré-équipement,
l'unité de commande comportant les dispositifs de détection suivants

a) pour détecter une quantité de clusters,
b) pour détecter un nombre de jeux de tables de changement vides,
c) pour détecter la durée respective pour la réalisation de l'armature pour un cluster,
d) pour détecter la durée de production respective pour la fabrication d'un cluster sur la ligne de montage,
e) pour sélectionner un ordre d'équipement dans lequel les jeux de tables de changement peuvent être équipés dans la zone de pré-équipement dans le but d'éviter des temps d'attente dans la production dans laquelle les mêmes jeux de tables de changement sont utilisés pour la production des circuits imprimés et
f) des moyens pour optimiser l'ordre chronologique des clusters compte tenu de l'ordre d'équipement sélectionné, de sorte que le rendement sur la ligne de montage est maximisé, ainsi que
g) des moyens pour exécuter la production des circuits imprimés à l'aide de l'ordre chronologique optimisé des clusters, et

en outre les moyens suivants :

- pour détecter un ou plusieurs instants les plus précoces possibles pour le début de l'utilisation d'un jeu de tables de changement,
- pour détecter un instant le plus précoce possible pour le début de la production,
- pour détecter un instant le plus précoce possible pour le début de l'équipement dans la zone de pré-équipement et
- pour optimiser l'ordre des clusters compte tenu des instants les plus précoces détectés.

7. Produit de programme informatique avec des moyens de code de programme pour exécuter le procédé selon l'une des revendications précédentes lorsqu'il tourne sur un dispositif de commande selon la revendication précédente.

# FIG 1

FIG 2

FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014222936 A1
- WO 2016074857 A1